Europäisches Patentamt

European Patent Office

Office européen des brevets

(19)

(11) Numéro de publication: **0 259 207**
**B1**

(12) **FASCICULE DE BREVET EUROPEEN**

(45) Date de publication du fascicule du brevet: **19.12.90**

(21) Numéro de dépôt: **87401816.1**

(22) Date de dépôt: **05.08.87**

(51) Int. Cl.⁵: **G 05 F 3/24,** H 01 L 29/64,
H 01 L 21/28, H 01 L 27/06

(54) Source de courant de type charge active, et son procédé de réalisation.

(30) Priorité: **19.08.86 FR 8611836**

(43) Date de publication de la demande:
**09.03.88 Bulletin 88/10**

(45) Mention de la délivrance du brevet:
**19.12.90 Bulletin 90/51**

(84) Etats contractants désignés:
**BE DE GB IT NL SE**

(56) Documents cités:
**EP-A-0 152 615**
**EP-A-0 176 754**

**PROCEEDINGS OF THE IEEE, vol. 70, no. 1,
janvier 1982, pages 35-45, IEEE, New York, US;
S.I. LONG et al.: "High speed gaAs integrated
circuits"**

(73) Titulaire: **THOMSON-CSF**
**51, Esplanade du Général de Gaulle**
**F-92800 Puteaux (FR)**

(72) Inventeur: **Tung, Pham Ngu**
**Thompson-CSF SCPI 19, avenue de Messine**
**F-75008 Paris (FR)**

(74) Mandataire: **Taboureau, James et al**
**THOMSON-CSF SCPI**
**F-92045 Paris La Défense Cédex 67 (FR)**

## Description

La présente invention concerne une charge active, source de courant pour les circuits logiques rapides fonctionnant avec des transistors normalement bloqués. La structure de cette charge active lui permet de constituer une source de courant dont le courant est bien défini, quels que soient les dispersions dans la fabrication des plaquettes dans lesquelles sont réalisés lesdits circuits logiques, généralement en matériaux rapides de la famille III—V tel que GaAs. L'invention concerne également le procédé de fabrication de cette charge active.

Le développement des circuits logiques rapides est associé au développement des circuits intégrés sur arséniure de gallium, ou matériau binaire ou ternaire équivalent de la famille III—V, et aux transistors à effet de champ normalement bloqués ou normalement passants. Les circuits à transistors normalement bloqués sont les plus intéressants pour plusieurs raisons:

— ils ne nécessitent qu'une seule tension d'alimentation $V_{DD}$, et la masse,

— ils consomment très peu, de 20 à 100 µW par porte,

— leur facteur de mérite $P \cdot t_{pd}$ (puissance-×temps de propagation) est plus faible que pour les circuits à transistors normalement passants,

— leur densité d'intégration est élevée.

L-inconvénient des portes logiques à transistors normalement bloqués est que la technologie de fabrication est très sévère, et que de ce fait les rendements industriels ne sont pas remarquables.

Le circuit logique connu sous le nom de DCFL (Direct Coupled FET Logic) est donc très intéressant pour ses caractéristiques, et sa simplicité: il ne comporte qu'un seul étage, constitué par un (ou deux) transistor normalement bloqué, ou à enrichissement alimenté par une charge active fonctionnant en source de courant. Il est actuellement connu de réaliser la charge active avec un transistor normalement passant, ou à appauvrissement. Le circuit DCFL à enrichissement-appauvrissement est l'analogie de la logique NMOS développée sur silicium.

Cependant, la dispersion des résultats d'implantation, au cours des opérations de fabrication, fait que l'on peut obtenir deux types de charges actives:

— celles pour lesquelles le courant qu'elles débitent est inférieur à sa valeur nominale, mais dans ce cas on sait intervenir pour augmenter le courant,

— celles pour lesquelles le courant qu'elles débitent est supérieur à sa valeur nominale. Il faut alors trouver un moyen de réduction de ce courant, pour l'ajuster.

Une charge active est un transistor dans lequel la métallisation de grille est court-circuitée avec la métallisation de source: si cette charge est normalement passante, elle comporte sous sa métallisation de grille un canal à tension de seuil négative. Selon l'invention, le courant débité par une source de courant est réduit et ajusté au moyen d'au moins une seconde métallisation de grille sous laquelle le canal est à tension de seuil positive: elle bloque partiellement le passage du courant dans la charge.

La première grille, à tension de seuil négative, et la seconde grille, à tension de seuil positive, coopèrant pour que le courant bloqué par la seconde grille adjuste à sa valeur nominale le courant, excédentaire, que laisserait passer la première grille, en l'absence de la seconde grille.

De façon plus précise, l'invention concerne une source de courant de type charge active, fontionnant en association avec au moins un transistor à effet de champ de type "normalement bloqué" à tension de seuil positive, cette source de courant ayant elle-même la structure d'un transistor à effet de champ dont le drain est alimenté par une tension positive ($+V_{DD}$) et dont la métallisation de grille est reliée à la métallisation de source, et étant caractérisée en ce qu'elle comporte une première grille à tension de seuil négative ($V_T < 0$), contrôlant sur toute la largeur du dispositif le passage des charges électriques de la source vers le drain et au moins une deuxième grille, à tension de seuil positive ($V_T > 0$), et en contact électrique avec la première grille, ladite deuxième grille servant à ajuster le courant fourni par la charge active.

L'invention sera mieux comprise par la description d'un exemple de réalisation, qui s'appuie sur les figures jointes en annexes, qui représentent:

— figure 1: schéma électrique d'une porte logique de type DCFL, selon l'art connu,

— figure 2: vue en coupe de la charge active selon l'invention,

— figure 3: vue en plan de la charge active selon l'invention, au cours d'une étape intermédiaire de sa fabrication,

— figure 4: vue en plan de la charge active selon l'invention, dans sa phase achevée.

L'invention sera plus facilement comprise par un bref rappel préliminaire de la structure d'une porte logique de type DCFL et de son procédé de fabrication. Bien que l'invention s'applique également à d'autres circuits que les portes logiques, elle est surtout intéressante dans le cas d'une porte DCFL qui soutiendra l'exposé de l'invention.

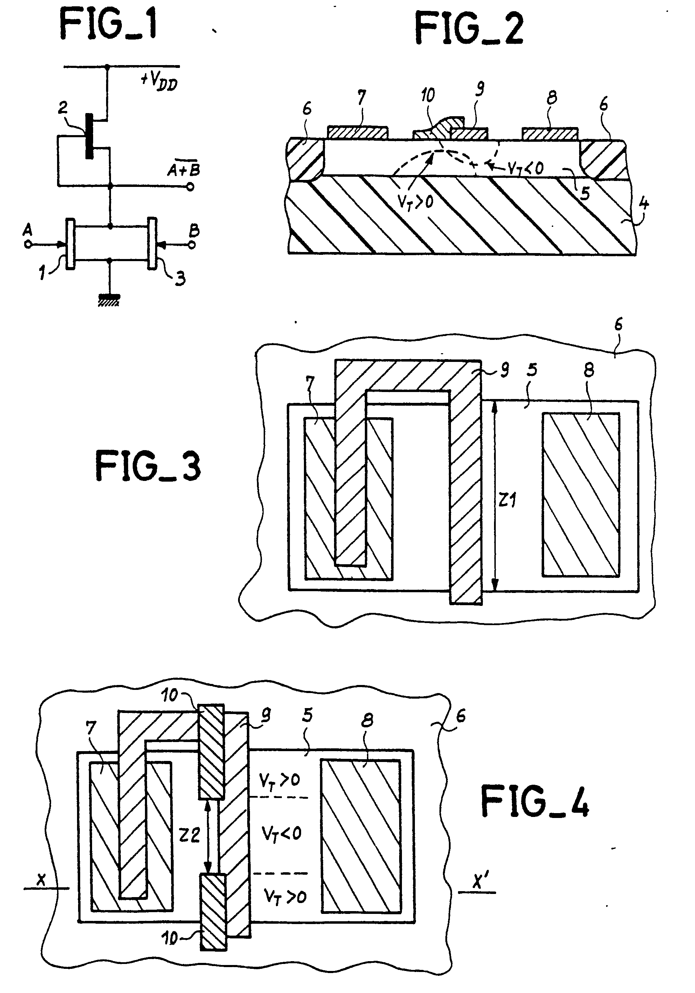

Une porte logique DCFL élémentaire est représentée en figure 1. Elle comporte au moins un transistor d'entrée 1, de type normalement bloqué, qui est alimenté par une charge active 2, constituant une source de courant, et qui est simplement un transistor à effet de champ dont la grille est réunie à la source. Dans certains cas, d'autres transistors d'entrée tel que 3 sont montés en parallèle sur le premier transistor d'entrée 1. Cette porte est alimentée par une tension unique $+V_{DD}$ sur le drain de la source de courant 2, et la source du transistor d'entrée 1 est à la masse. Le signal de sortie est prélevé au point commun entre le drain du transistor d'entré 1 et la source du transistor 2: dans le cas de la figure, si A et B sont les deux signaux d'entrée, le signal de sortie est $\overline{A+B}$.

On a découvert depuis quelque temps que les portes mixtes à enrichissement-appauvrissement ont des caractéristiques plus intéressantes que celles qui sont uniquement à enrichissement. C'est-à-dire qu'une porte mixte comporte:

— un transistor d'entrée 1 à enrichissement, de type normalement bloqué (Normally-off) et à tension de seuil $V_T$ positive,

— une charge active 2 à appauvrissement, de type normalement passant (Normally-on) et à tension de seuil $V_T$ négative.

La réalisation de ces circuits intégrés sur GaAs nécessite donc la réalisation de transistors à $V_T>0$ et de transistors à $V_T<0$, selon le schéma de fabrication suivant:

1/—sur un substrat de GaAs semi-isolant, implantation ou épitaxie de $Si^{28}$ pour réaliser les couches actives des transistors,

2/—Dépôt des contacts ohmiques de sources et drains,

3/—implantation de bore pour réaliser les caissons isolants,

4/—réalisation des charges actives à $V_T<0$

5/—réalisation des transistors à $V_T>0$

6/—dépôt de ponts de diélectrique s'il y a des croisements d'interconnexions, des métallisations d'interconnexions et de la couche de passivation.

Ces opérations sont tout à fait classiques, mais on sait par l'expérience que la dispersion des caractéristiques de couches actives obtenues par implantation de $Si^{28}$ est surtout en surface. Il s'ensuit que les transistors à $V_T>0$, fonctionnant dans les couches profondes, ont des caractéristiques relativement stables, tandis que les charges actives à $V_T<0$, fonctionnant dans les couches superficielles ont des courants très fluctuants avec les dispersions de l'implantation de $Si^{28}$.

Mais on a constaté également que les résultats d'une implantation de $Si^{28}$ sont homogènes au niveau d'une plaquette de matériau semiconducteur, de sorte que, pour une plaquette, tous—ou presque tous—les courants dans les charges sont uniformément soit inférieurs soit supérieurs au courant nominal: l'ajustage du courant de charge peut donc être une opération collective an niveau de la plaquette.

Le contrôle de la tension de seuil dans une charge active permet d'ajuster le courant dans un sens croissant. Si le courant dans une charge est inférieur à sa valeur nominale, on peut l'ajuster au moyen d'un complément d'implantation de $Si^{28}$. Mais si le courant dans une charge est supérieur à sa valeur nominale, il faut un moyen de réduction pour l'ajuster.

Etant donné que le contrôle du courant dans les charges actives d'une plaquette ne peut se faire qu'après la quatrième étape du procédé de fabrication précité, la réduction ne peut intervenir qu'à la cinquième étape.

Selon l'invention, si une charge active laisse passer un courant trop important, celui-ci est diminué et ajusté en déposant, à proximité de la grille à tension de seuil négative de la charge de courant au moins, une seconde grille à tension de seuil positive, qui limite la largeur sur laquelle passe le courant entre source et drain. Cette seconde grille est déposée en même temps que la grille du transistor d'entrée 1 à tension de seuil positive.

La figure 2 représente une vue en coupe d'une charge active selon l'invention: pour être bien comprise, elle doit être lue en conjonction avec la figure 4. La figure 2 est une coupe au niveau de l'axe XX' de la figure 4.

Dans une charge active, un substrat semi-isolant 4 supporte une couche conductrice 5, implantée ou épitaxiée, limitée en surperficie par un caisson rendu isolant 6. Deux métallisations ohmiques 7 et 8 servent d'électrodes de source et de drain, et une métallisation 9, réunie à la source, sert de grille. Il est d'usage de définir la longueur de grille selon un axe tel que XX' qui va de la source vers le drain, et la largeur $Z_1$ de grille selon un axe parallèle aux métallisations de source et de drain.

Cette charge active est à appauvrissement, c'est-à-dire à tension de seuil $V_T<0$. Puisqu'elle a été trouvée, par mesure en cours de fabrication (étape 4) trop conductrice, l'invention prévoit de réduire le courant qui la traverse en lui ajoutant au moins une seconde électrode de grille 10, qui est à enrichissement et à tension de seuil positive $V_T>0$. En fait, il est préférable d'ajouter deux fractions de seconde électrode 10: cela permet de mieux contrôler la largeur $Z_2$ de grille dans laquelle la première grille 9 à tension de seuil négative reste active.

En raison de l'incertitude de positionnement du second masque, qui sert à faire la seconde grille 10, par rapport au premier masque, qui sert à faire la première grille 9, les deux grilles 9 et 10 sont soit superposées, soit chevauchées (cas des figures 2 et 4) soit côte à côte, mais toujours en contact électrique entre elles. Ainsi, la seconde grille 10 est en contact électrique avec la source 7, par l'intermédiaire de la première grille 9. La seconde grille 10 est donc à la mass à travers le transistor d'entrée 1 lorsque celui-ci est conducteur: dans ces conditions, le courant ne passe plus sous la seconde grille 10, puisque sa tension de seuil $V_T$ est positive. L'action de la première grille 9 est limitée à la zône de largeur Z2.

La figure 3 représente une charge active selon l'invention, au cours d'une étape intermédiaire de sa fabrication.

Dans une plaquette 4 de GaAs semi-isolant a été créée par implantation de $Si^{28}$ une couche active 5, qui servira aussi bien pour le transistor d'entrée 1 et pour la charge active 2 (étape 1). Les métallisations de contacts ohmiques 7 et 8—ainsi que celles du transistor d'entrée 1—sont déposées sur la couche active 5 (étape 2), et les caissons isolants 6 qui délimitent la charge active 2 et le transistor d'entrée 1 sont créés dans la plaquette par implantation de bore (étape 3). La surface de la plaquette est alors masquée par un masque, qui ne découvre que la partie de la future première grille 9 qui est effectivement sur la couche active 5: un bombardement protonique, par des moyens connus, permet de déterminer le réseau cristallin dans la région où l'on désire une tension de seuil négative $V_T < 0$, sur toute la largeur $Z_1$ de grille. Ensuite la métallisation de grille 9 est déposée (étape 4) par le procédé lift-off.

Selon l'invention, les plaquettes en cours de fabrication sont alors mesurées en courant de charge et triées. Pour celles qui ont un courant de charge trop important, l'opérateur choisit, parmi une pluralité de masques, celui qui va permettre de déposer une seconde électrode de grille 10 qui diminue le courant dans la charge d'une valeur adéquate: par exemple 10%, ou 25% ou quelqu'autre valeur.

Le masque—ou plus exactement le jeu de masques—utilisé dans l'étape 5 a donc la particularité de définir à la fois la seconde grille 10 de la charge active 2 et la grille du transistor d'entrée 1: elles sont toutes deux à tension de seuil positive, et sont fabriquées simultanément par un autre bombardement protonique qui crée, sous les futures métallisations de grilles, des régions à tension de seuil positive: sur la figure 4, ce sont les régions de la couche active 5, à l'intérieur des ouvertures de la seconde grille 10, qui sont ainsi transformées en régions à tension de seuil positive. Après ce bombardement, les métallisations de la seconde grille 10 de la charge active 2 et de la grille du transistor d'entrée 1 sont déposées (étape 5).

La suite des opérations est classique et comprend les étapes nécessitées par la complexité du circuit intégré:
— dépôt de ponts de diélectrique pour les croisements d'interconnexions,
— dépôt des pistes métalliques d'interconnexions et des plots de liaisons extérieures,
— dépôt d'une couche de passivation.

Les charges actives selon l'invention ont plusieurs avantages:
— les courants dans les charges sont ajustables, par le choix du masque de réalisation de la grille 10 à tension de seuil positive,
— toutes les portes logiques DCFL d'un circuit intégré complexe ont les mêmes courants de charges,
— linéarité des courants. Les grilles des transistors et des charges actives ont même finesse, submicronique, et la distance $Z2$ entre deux fractions de seconde grille 10 peut être précise à 1 micron près. Il est donc possible de réaliser des charges actives ayant chacune une longueur $Z2$ bien spécifique, de sorte que l'on peut obtenir des courants multiples d'un courant de référence de faible valeur, ce qui convient aux circuits linéaires comme les convertisseurs analogique-numérique ou numérique-analogique.

L'invention permet donc de réaliser des circuits intégrés de grande complexité, de grande rapidité avec cependant un bon rendement de fabrication puisque les plaquettes pour lesquelles un courant de charge trouvé trop important sont récupérées par ajustage du courant de charge.

Bien que l'invention ait été exposée en s'appuyant sur l'exemple d'une porte logique de type DCFL en GaAs, il est bien évident qu'elle concerne tous les transistors à tension de seuil négative, dont on veut ajuster le courant qui le traverse, par adjonction d'une grille à tension de seuil positive, et quel que soit le matériau semiconducteur:silicium ou matériaux tels que InP ou GaAlAs . . . etc. Bien entendu, les conditions des opérations connues d'implantation et de bombardement sont alors adaptées au matériau considéré.

## Revendications

1. Source de courant de type charge active, fonctionnant en association avec au moins un transistor à effet de champ (1) de type "normalement bloqué" à tension de seuil positive, cette source de courant ayant elle-même la structure d'un transistor à effet de champ (2) dont le drain (8) est alimenté par une tension positive ($+V_{DD}$) et dont la métallisation de grille (9) est reliée à la métallisation de source (7), et étant caractérisée en ce qu'elle comporte une première grille (9) à tension de seuil négative ($V_T < 0$), contrôlant sur toute la largeur du dispositif le passage des charges électriques de la source (7) vers le drain (8) et au moins une deuxième grille (10), à tension de seuil positive ($V_T > 0$), et en contact électrique avec la première grille (9), ladite deuxième grille (10) servant à ajuster le courant fourni par la charge active.

2. Source de courant selon la revendication 1, caractérisée en ce que les deux grilles (9, 10) sont parallèles entre elles, et en ce que la métallisation de la deuxième grille (10) recouvre au moins partiellement la métallisation de la première grille (9) pour assurer le contact électrique entre elles.

3. Source de courant selon la revendication 1, caractérisée en ce que, lorsque la deuxième grille (10) est portée à une tension nulle ou inférieure à sa tension de seuil ($V_T > 0$), elle bloque le passage du courant dans la partie correspondante de la première grille (9).

4. Source de courant selon la revendication 1, caractérisée en ce que le courant qui la traverse est ajusté par le choix de la largeur ($Z2$) de la première grille (9) qui n'est pas contrôlée par la deuxième grille (10).

5. Source de courant selon la revendication 1, comportant deux sections de deuxième grille (10) caractérisée en ce que le courant qui la traverse est ajusté par le choix de la distance ($Z2$) qui sépare les deux sections de la deuxième grille (10).

6. Procédé de fabrication d'une source de courant dans un circuit intégré selon l'une quelconque des revendications 1 à 5, comportant des étapes préliminaires de:
— réalisation de la couche active (5) sur un substrat (4) de matériaux semiconducteur,
— dépôt des métallisations de contact ohmique de source et drain (7, 8)

— réalisation du caisson isolant (6)

— bombardement protonique de la région de la première grille (9) pour créer une zone à tension de seuil négative ($V_T < 0$).

— dépôt de la métallisation de contact de première grille (9), caractérisé en ce qu'il comporte les étapes de:

— mesure du courant qui traverse la charge active, et détermination de la largeur de la seconde grille (10) nécessaire pour ajuster ce courant,

— bombardement protonique de la région de la deuxième grille (10) pour créer au moins une zone à tension de seuil positive ($V_T > 0$)

— dépôt de la métallisation de contact de deuxième grille (10),

l'achèvement du circuit intégré se faisant par des opérations de dépôts de métallisations et de ponts diélectriques pour les interconnexions.

7. Procédé de fabrication d'une source de courant dans un circuit intégré, selon la revendication 6, caractérisé en ce que les étapes de réalisation de la deuxième grille (10) comportent simultanément la réalisation des transistors (1, 3) du circuit intégré à tension de seuil positive ($V_T > 0$).

**Patentansprüche**

1. Stromquelle vom Typ eines aktiven Lastelementes, die in Verbindung mit wenigstens einem Feldeffekttransistor (1), der vom "normalerweise gesperrten" Typ ist und eine positive Schwellenspannung besitzt, arbeitet und selbst die Struktur eines Feldeffekttransistors (2) besitzt, dessen Drain (8) mit einer positiven Spannung ($+V_{DD}$) versorgt wird und dessen Gatemetallisierung (9) mit der Sourcemetallisierung (7) verbunden ist, dadurch gekennzeichnet, daß sie ein erstes Gate (9) mit negativer Schwellenspannung ($V_T < 0$), das auf der gesamten Breite der Einrichtung den Fluß der elektrischen Ladungen von der Source (7) zum Drain (8) steuert, und wenigstens ein zweites Gate (10) mit positiver Schwellenspannung ($V_T > 0$), das mit dem ersten Gate (9) in elektrischem Kontakt ist und zur Einstellung des vom aktiven Lastelement gelieferten Stroms dient, umfaßt.

2. Stromquelle gemäß Anspruch 1, dadurch gekennzeichnet, daß die zwei Gates (9, 10) zueinander parallel geschaltet sind und daß die Metallisierung des zweiten Gates (10) mit der Metallisierung des ersten Gates (9) wenigstens teilweise überlappt, um den elektrischen Kontakt zwischen ihnen zu gewährleisten.

3. Stromquelle gemäß Anspruch 1, dadurch gekennzeichnet, daß das zweite Gate (10), wenn es auf einer Spannung gehalten wird, die Null oder kleiner als seine Schwellenspannung ($V_T > 0$) ist, den Stromfluß im entsprechenden Abschnitt des ersten Gates (9) sperrt.

4. Stromquelle gemäß Anspruch 1, dadurch gekennzeichnet, daß der durch sie fließende Strom durch die Wahl der Breite (Z2) des ersten Gates (9), die nicht durch das zweite Gate (10) gesteuert wird, eingestellt wird.

5. Stromquelle gemäß Anspruch 1, die zwei Abschnitte des zweiten Gates (10) aufweist, dadurch gekennzeichnet, daß der durch sie fließende Strom durch die Wahl des die zwei Abschnitte des zweiten Gates (10) trennenden Abstandes (Z2) eingestellt wird.

6. Verfahren zur Herstellung einer Stromquelle in einer integrierten Schaltung gemäß einem der Ansprüche 1 bis 5, mit den vorbereitenden Schritten

— des Herstellens einer aktiven Ladungsschicht (5) auf einem Substrat (4) aus Halbleitermaterial,

— des Niederschlages von Metallisierungen für ohmische Kontakte de Source und des Drains (7, 8),

— des Herstellens eines Isolierfeldes (6),

— des Protonenbeschusses des Bereichs des ersten Gates (9), um eine Zone mit negativer Schwellenspannung ($V_T < 0$) zu erzeugen, und

— des Niederschlages der Kontaktmetallisierung des ersten Gates (9),

dadurch gekennzeichnet, daß es die Schritte

— des Messens des durch das aktive Ladungselement fließenden Stromes und des Bestimmens der für die Einstellung dieses Stromes notwendigen Breite des zweiten Gates (10),

— des Protonenbeschusses des Bereichs des zweiten Gates (10), um wenigstens eine Zone mit positiver Schwellenspannung ($V_T > 0$) zu erzeugen, und

— des Niederschlages der Kontaktmetallisierung des zweiten Gates (10)

umfaßt, wobei die Fertigstellung der integrierten Schaltung durch Vorgänge des Niederschlages von Metallisierungen und von elektrischen Brücken für die Zwischenverbindungen geschieht.

7. Verfahren zur Herstellung einer Stromquelle in einer integrierten Schaltung gemäß Anspruch 6, dadurch gekennzeichnet, daß die Schritte des Herstellens des zweiten Gates (10) gleichzeitig die Herstellung derjenigen Transistoren (1, 3) der integrierten Schaltung, die eine positive Schwellenspannung ($V_T > 0$) besitzen, umfassen.

**Claims**

1. A power supply of the active load type, adapted to operate in association with at least one field effect transistor (1) of the "normally off type" with a positive voltage threshold, said power supply having itself the structure of a field effect transistor (2) whose drain (8) is supplied by a positive voltage ($+V_{DD}$) and whose gate metallized layer (9) is connected with the metallized layer of the source (7), and being characterized in that it comprises a first gate (9) with a negative threshold voltage ($V_T < 0$), controlling along the full width of the device the passage of the electrical charges from the source (7) towards the drain (8) and at least a second gate (10) with a positive threshold voltage ($V_T > 0$) and in electrical contact with the first gate (9), the said second gate (10) serving to adjust the current supplied by the active load.

2. The power supply as claimed in claim 1, characterized in that the two gates (9 and 10) are mutually parallel and in that the metallized layer of the second gate (10) at least partly covers the metallized layer of the first gate (9) in order to provide electrical contact therebetween.

3. The power supply as claimed in claim 1, characterized in that when the second gate (10) is brought to a voltage equal to zero or less than its threshold voltage ($V_T > 0$) it prevents the passage of the power in the corresponding part of the first gate (9).

4. The power supply as claimed in claim 1, characterized in that the current therethrough is adjusted by the selection of the width (Z2) of the first gate (9) which is not controlled by the second gate (10).

5. The power supply as claimed in claim 1, comprising two second gate sections (10) characterized in that the current through the power supply is adjusted by the selection of the distance (22) between the two sections of the second gate (10).

6. A method for the manufacture of a power supply in an integrated circuit as claimed in any one of the preceding claims 1 through 5, comprising the preliminary steps of:

— producing the active layer (5) on a substrate (4) of semiconductor material,

— deposit of ohmic contact source and drain metallized layers (7 and 8),

— production of the insulating island (6),

— proton bombardment of the region of the first gate (9) in order to create a negative voltage threshold zone ($V_T < 0$),

— deposit of the first gate contact metallized layer (9), characterized in that it comprises the stages of:

— measuring the current through the active load and ascertainment of the width of the second gate (10) necessary in order to adjust this current,

— proton bombardment of the second gate region (10) in order to create at least one positive voltage threshold zone ($V_T > 0$), and

— deposition of the second gate contact metallized layer (10),

the completion of the integrated circuit being performed by metallized layer deposit operations and dielectric bridge operations for interconnections.

7. The method of manufacturing a power supply in an integrated circuit as claimed in claim 6, characterized in that the stages of producing the second gate (10) simultaneously comprise the production of transistors (1 and 3) of the integrated circuit, said transistors being positive threshold transistors ($V_T > 0$).

**FIG_1**

**FIG_2**

**FIG_3**

**FIG_4**